# EUROPÄISCHE PATENTSCHRIFT

(11) **EP 1 448 890 B1**
(45) Veröffentlichungstag und Bekanntmachung des Hinweises auf die Patenterteilung: **12.07.2006**
(21) Anmeldenummer: 02776848.0
(22) Anmeldetag: 24.10.2002
(51) Int. Cl.: F02P 23/04

(54) **HOCHFREQUENZZÜNDUNG FÜR EINE BRENNKRAFTMASCHINE**
HIGH-FREQUENCY IGNITION FOR AN INTERNAL COMBUSTION ENGINE
ALLUMAGE HAUTE FREQUENCE CONCU POUR UN MOTEUR A COMBUSTION INTERNE

(30) Priorität: 21.11.2001 DE 10157029
(43) Veröffentlichungstag der Anmeldung: 25.08.2004
(73) Patentinhaber: ROBERT BOSCH GMBH, 70442 Stuttgart (DE)
(72) Erfinder: SCHLEUPEN, Richard, 74379 Ingersheim (DE); WIZEMANN, Thomas, 71642 Ludwigsburg (DE)
(86) Internationale Anmeldenummer: PCT/DE2002/004000
(87) Internationale Veröffentlichungsnummer: WO 2003/046374

(56) Entgegenhaltungen:
- DE-A- 10 015 613
- DE-A- 19 852 652
- GB-A- 2 080 877
- US-A- 5 361 737
- BONAZZA T J ET AL: "RF PLASMA IGNITION SYSTEM CONCEPT FOR LEAN BURN INTERNAL COMBUSTION ENGINES" ENERGY SYSTEMS, NEW TECHNOLOGIES. SAN DIEGO, AUG. 3 - 7, 1992, PROCEEDINGS OF THE INTERSOCIETY ENERGY CONVERSION ENGINEERING CONFERENCE (IECEC), NEW YORK, IEEE, US, Bd. 4 CONF. 27, 3. August 1992 (1992-08-03), Seiten 4315-4319, XP000384708 ISBN: 0-7803-0693-7

## Beschreibung

### Stand der Technik

Die Erfindung geht aus von einer Hochfrequenzzündung nach der Gattung des unabhängigen Patentanspruchs. Aus der DE 198 52 652 ist bereits eine Hochfrequenzzündung bekannt, bei der ein Wellenleiter und ein Hochfrequenzverstärker vorgesehen sind. Das eine Ende des Wellenleiters ragt in den Brennraum eines Verbrennungsmotors und bildet dabei eine Zündstrecke. An dem anderen Ende des Wellenleiters ist der Hochfrequenzverstärker angeschlossen. Wenn von dem Hochfrequenzverstärker ein passendes hochfrequentes Signal erzeugt wird, werden in der Zündstrecke Zündfunken erzeugt, die zur Zündung eines verbrennungsfähigen Gemisches in einem Zylinder eine Brennkraftmaschine genutzt werden.

Aus Bonazza et. al. "Rf Plasma Ignition..." Energy Systems, San Diego, Aug. 3 - 7, 1992, Proceedings of the IECEC, New York, IEEE, US, Bd. 4 Conf. 27,3. Aug. 1992 Seiten 4315 ff. ist bereits eine HF Zündung zur Anwendung in einem Kraftfahrzeug bekannt. Weitere HF Zündsysteme sind aus der US 5,361,737 und der DE 100 15 613 bekannt.

### Vorteile der Erfindung

Die erfindungsgemäße Hochfrequenzzündung hat demgegenüber den Vorteil, dass ein Mitkoppelelement vorgesehen ist, durch das die Frequenz des Hochfrequenzverstärkers an die Lastverhältnisse des Wellenleiters angepasst wird. Durch diese Maßnahme wird erreicht, dass in allen Betriebszuständen zuverlässig ein Zündfunke erzeugt werden kann. Dies gilt insbesondere auch für den Fall, dass bereits ein Zündfunke an der Zündstrecke brennt, da dies zu einer Veränderung der Lastverhältnisse des Wellenleiters führt.

Vorteilhafte Weiterbildungen und Verbesserungen ergeben sich durch die Merkmale der abhängigen Patentansprüche. Besonders einfach wird der Hochfrequenzverstärker als Transistor, insbesondere als Feldeffekttransistor, ausgebildet. Die Mitkoppelung kann insbesondere als induktive Mitkopplung oder als induktive und kapazitive Mitkopplung ausgebildet werden. Für die induktive Mitkopplung kann ein Koaxleiter im Bereich des magnetischen Feldes des Wellenleiters angeordnet werden. Wenn die Mitkopplung induktiv und kapazitiv erfolgt wird der Wellenleiter besonders einfach als Koaxialelement ausgebildet, wobei das Mitkoppelelement besonders einfach durch einen Leiter gebildet wird, der parallel zum Mittelleiter innerhalb der Abschirmung angeordnet ist.

### Zeichnungen

Ausführungsbeispiele der Erfindung werden in den Zeichnungen dargestellt und in der nachfolgenden Beschreibung näher erläutert. Es zeigen
Figur 1 eine erste Schemaansicht der erfindungsgemäßen Hochfrequenzzündung, wobei die Mitkopplung stark schematisiert ist,
Figur 2 ein erstes Ausführungsbeispiel der Mitkopplung und
Figur 3 ein weiteres Ausführungsbeispiel für die Mitkopplung.

### Beschreibung der Erfindung

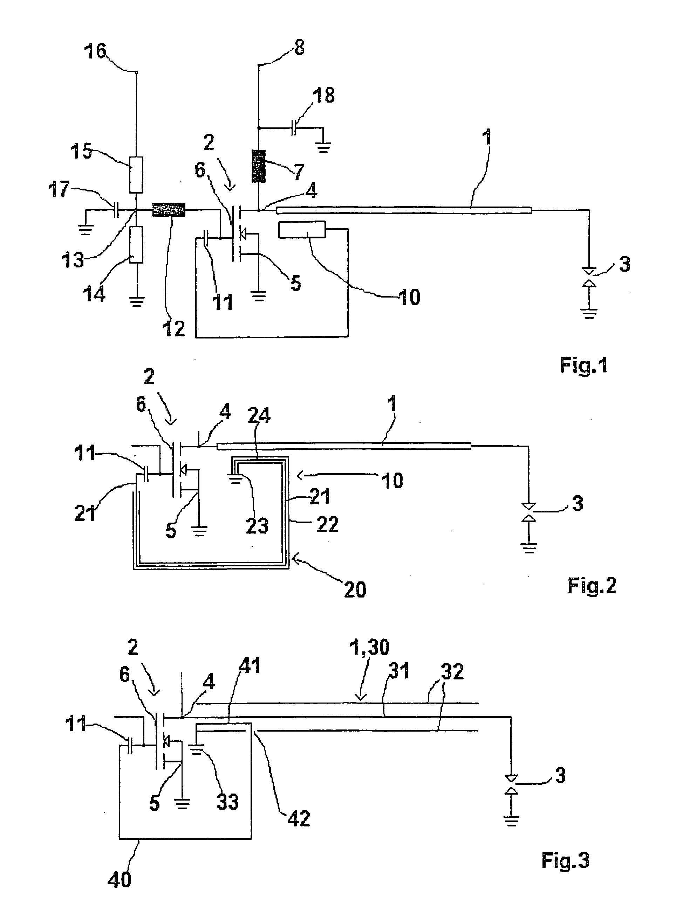

In der Figur 1 wird eine schematische Ansicht einer erfindungsgemäßen Hochfrequenzzündung gezeigt. Die Hochfrequenzzündung weist einen Wellenleiter 1 auf, an dessen einem Ende eine Zündstrecke 3, insbesondere eine Zündkerze angeordnet ist. Die Zündkerze ragt in den Brennraum (Zylinder) einer Brennkraftmaschine insbesondere eines Benzinmotors und dient zu Zündung eines im Brennraum angeordneten zündfähigen Gemischs von Luft und Kraftstoff (Benzin). Am anderen Ende des Wellenleiters 1 ist ein Hochfrequenzverstärker 2, der hier als Feldeffekttransistor ausgebildet ist, dargestellt. Der gesammte Aufbau von Hochfrequenzverstärker 2 und Wellenbleiter 1 bilden einen Hochfrequenzgenerator durch den ein Hochfrequenzsignal erzeugt werden kann. Der Feldeffekttransistor ist mit einem Drainanschluss 4 an einem ersten Ende eines Wellenleiters 1 angeschlossen. Weiterhin weist der Feldeffekttransistor 2 einen Sourceanschluss 5 auf, der mit Masse verbunden ist. Der Feldeffekttransistor 2 weist weiterhin einen Gateanschluss 6 auf.

Durch Anlegen einer positiven Spannung kann das Gate leitend geschaltet werden, das heißt es wird dann ein Stromfluss zwischen dem Drain 4 und dem Source 5 ermöglicht. Das Source 5 ist mit einem Masseanschluss verbunden. Das Drain 4 ist über eine Drosselspule 7 mit einem Spannungsanschluss 8 verbunden.

Wenn an dem Gate ein hochfrequentes Steuersignal anliegt, so wird auf dem Wellenleiter 1 ein Hochfrequenzsignal erzeugt. Wenn dabei die Frequenz des Hochfrequenzsignals optimal an die Lastverhältnisse des Wellenleiters 1 beziehungsweise eine sich eventuell noch daran anschließende Zuleitung zur Zündstrecke 3 angepasst ist, so wird in der Zündstrecke 3 ein Hochfrequenzsignal mit sehr hohen Spannungen erzeugt. Diese Spannungen ist so hoch, dass in der Zündstrecke 3 ein Zündfunke von dem Wellenleiter 1 über die Zündstrecke 3 nach Masse überspringt. Die dafür erforderlichen Spannungen liegen in der Größenordnung von einigen tausend Volt.

Erfindungsgemäß wird nun vorgeschlagen, diese Hochspannungsfunken zur Zündung einer Brennkraftmaschine zu nutzen. Dabei ist jedoch zu beachten, dass in dem Augenblick, in dem ein Zündfunke an der Zündstrecke 3 zwischen dem Wellenleiter 1 und dem Masseanschluss überspringt, sich die Lastverhältnisse des Wellenleiters 1 ändern. Die Transformationsverhältnisse des Wellenleiters hängen nämlich auch davon ab, welchen Widerstand die Zündstrecke gegenüber Masse hat. Bevor ein Zündfunke überspringt, ist dieser Widerstand sehr groß. Durch den Zündfunken wird jedoch in der Zündstrecke ein ionisiertes Gas erzeugt, welches eine gewisse Leitfähigkeit aufweist. Dieses ionisierte Gas führt dazu, dass der Wellenleiter 1 an dem Ende, das dem Hochfrequenzverstärker 2 entgegengesetzt angeordnet ist, mit einem endlichen Widerstand abgeschlossen wird. Dies hat Einfluss auf die Transformationsverhältnisse des Wellenleiters 1. Nur wenn der Hochfrequenzverstärker 2 durch eine entsprechende Frequenzänderung auf diese Änderung des Abschlusswiderstandes des Wellenleiters 1 reagiert, lässt sich die frequenzmäßige Anpassung und somit auch die Erzeugung eines Hochspannungssignals aufrechterhalten.

Erfindungsgemäß wird nun vorgeschlagen, diese Frequenzanpassung durch ein Mitkoppelelement 10 zu bewerkstelligen. In der Figur 1 wird dies Mitkoppelelement nur schematisch gezeigt. In den Figuren 2 und 3 werden dann konkrete technische Ausführungsbeispiele für dieses Mitkoppelelement gezeigt. Das Mitkoppelelement 10 ist daher in der Figur 1 nur schematisch als Block dargestellt, ohne auf die genaue Funktion dieses Mitkoppelelements einzugehen.

Das Mitkoppelelement 10 ist über eine entsprechende Leitung und einen Abkoppelkondensator 11 mit dem Gate 6 des Hochfrequenz erzeugenden Transistors 2 verbunden. Weiterhin ist das Gate 6 des Transistors 2 über eine Drosselspule 12 mit einem Abgriff 13 eines Spannungstellers verbunden. Der Spannungsteiler weist zwischen dem Abgriff 13 und dem Masseanschluss einen ersten Widerstand 14 auf. Zwischen dem Abgriff 13 und einem Signalanschluss 16 ist ein zweiter Widerstand 15 angeordnet. Weiterhin ist der Abgriff 13 über einen Ableitkondensator 17 mit Masse verbunden.

Die so aufgebaute Zündvorrichtung funktioniert wie folgt. An den Signalanschluss 16 wird ein Rechtecksignal angelegt, dessen Dauer der gewünschten Zeitdauer des Zündfunken entspricht. Üblicherweise wird daher das am Anschluss 16 angelegte Signal in der Größenordnung von einigen Millisekunden Zeitdauer sein. Wenn am Anschluss 16 eine positive Spannung angelegt wird, so wird auch der Abgriff 13 auf eine positive Spannung eingestellt, deren Wert von der Spannung am Signalanschluss 16 und von dem ersten und zweiten Widerstand 14 und 15 abhängt. Dieses positive Potenzial wird über die Drosselspule 12 dem Gateanschluss 6 zugeführt.

Wenn an dem Gateanschluss 6 keine Spannung anliegt, so ist der Transistor 2 nicht leitend, so dass am Drain 4 und somit auch am ersten Ende des Wellenleiters 1 die Versorgungsspannung anliegt, die am Anschluss 8 zur Verfügung gestellt wird.

Wenn nun am Drain 6 aufgrund des Signals am Signalanschluss 16 eine positive Spannung anliegt, so wird der Transistor 2 leitend geschaltet und Drain 4 zeihet Strom. Durch das Rauschsignal wird die Schaltung bevorzugt im Bereich geringster Dämpfung (Resonanz) über das Mitkoppelelement 10 auf das Gate 6 zurückgekoppelt. Durch diese Mitkopplung wird somit das Gate mit der Frequenz angesteuert, die auf dem Wellenleiter 1 zu den größten Strom- und Spannungsamplituden führt.

Der Hochfrequenzverstärker 2 wird durch die Mitkopplung somit auf die Frequenz eingestellt, die optimal an den Quellwiderstand und die Last des Wellenleiters 1 angepasst ist (Resonanz). Wenn dann die Spannungsdifferenz zwischen dem Wellenleiter 1 und dem Masseanschluss in der Zündstrecke 3 ausreichend groß ist, kommt es zur Ausbildung eines Zündfunkens, das heißt es fließt Energie von dem Wellenleiter 1 über die Zündstrecke 3 zur Masse. Da sich in der Zündstrecke 3, das heißt der Zündkerze im Brennraum einer Brennkraftmaschine ionisiertes Gas ansammelt, ist der Wellenleiter 1 über die Zündstrecke 3 mit einem endlichen Widerstand mit Masse verbunden. Durch diese Veränderung des Widerstands am zündseitigen Ende des Wellenleiters 1 müßte zur Beibehaltung der Resonanz entweder die Länge des Wellenleiters 1 oder die Frequenz des Hochfrequenzverstärkers 2 verändert werden, um nach wie vor eine optimale Anpassung an die Last zu gewährleisten. Nur unter dieser Voraussetzung lässt sich am zündseitigen Ende des Wellenleiters 1 eine ausreichend hohe Spannung zur Ausbildung eines Zündfunkens in der Zündstrecke 3 zur Verfügung stellen. Durch die Gesamtschaltung erfolgt diese Frequenzanpassung des Hochfrequenzverstärkers 2 automatisch auf die Frequenz bei der die Dämpfung am geringsten und damit die Leistungsanpassung am besten ist.

Durch die erfindungsgemäße Vorrichtung wird somit automatisch eine Frequenzanpassung des Hochfrequenzverstärkers 2 an die Lastverhältnisse am zündseitigen Ende des Wellenleiters 1 gewährleistet. Diese Frequenzanpassung bewirkt sowohl beim Einschalten der Vorrichtung wie auch beim Überspringen eines Zündfunkens in der Zündstrecke 3 eine optimale Lastanpassung. Es wird so sichergestellt, dass während der gesamten Zeitdauer, während der ein entsprechendes Ansteuersignal am Anschluss 16 zur Verfügung gestellt wird, ein Zündfunke in der Zündstrecke 3 brennt.

In der Figur 1 werden eine Vielzahl von Elementen gezeigt, die eine frequenzmäßige An- und Abkopplung des Wellenleiters gegenüber anderen Spannungen ermöglichen. Durch den Abkoppelkondensator 11 wird gewährleistet, dass nur Wechselspannungen vom Mitkoppelelement 10 auf das Gate 6 zurückgekoppelt werden. Der Kondensator 11 stellt somit einen Hochpass dar. Weiterhin wird so verhindert, dass die an das Gate 6 angelegte Gleichspannung über den Wiederstand des Mitkoppelelements 10 beeinflußt wird. Die Drosselspule 7 ist nicht nur mit der Spannungsversorgung 8, sondern auch über einen Kondensator 18 mit Masse verbunden. Die Drosselspule 7 und der Ableitkondensator 18 dienen hier als Tiefpass, um ein Einkoppeln des HF-Signals auf dem Wellenleiter 1 auf die Spannungsversorgung 8 zu verhindern. Entsprechend wirken die Drosselspule 12 und der Kondensator 17 als Tiefpass, um eine Einkopplung des HF-Signals am Gate auf den Signalanschluss 16 zu vermindern. Die Widerstände 14 und 15 dienen als Spannungsteiler dazu, eine Anpassung des am Anschluss 16 angelegten Signals an den Ansteuerbereich des Transistors 2 vorzunehmen.

In der Figur 2 wird detailliert die Ausgestaltung eines Mitkoppelelements 10 gezeigt. Die Bezugszahlen 1, 2, 3, 4, 5, 6 und 11 bezeichnen wieder die gleichen Gegenstände wie bei der Figur 1, die auch die gleichen Funktionen wie zur Figur 1 beschrieben, wahrnehmen. Der Wellenleiter 1 ist hier insbesondere als Streifenwellenleiter ausgebildet. Das Mitkoppelelement 10 ist hier als Koaxialleitung 20 mit einem Mittelleiter 21 und einer äußeren Abschirmung 22 ausgeführt. Ein Ende 23 der Koaxialleitung 20 ist mit Masse verbunden. Dabei sind der Innenleiter 21 und die Abschirmung 22 mit Masse verbunden. Ausgehend von dem Ende 23 erstreckt sich ein Ankoppelbereich 24 der Koaxialleitung 20 parallel zum Wellenleiter 1. Dabei ist das Ende 23 dem Drainanschluss 4 des Wellenleiters 1 benachbart, so dass sich der Ankoppelbereich 24 ausgehend von Ende 23 weg vom Drainanschluss 4 entlang des Wellenleiters 1 hin zur Zündstrecke 3 erstreckt. Anschließend an den Ankoppelbereich 24, wird die Koaxialleitung 20 im wesentlichen senkrecht und danach in großer Entfernung vom Wellenleiter 1 weggeführt.

Die Wirkung dieser Vorrichtung ist so, dass durch die parallele Anordnung des Ankoppelbereichs 24 dieser im Bereich des magnetischen Feldes des Wellenleiters 1 liegt. Ein hochfrequentes Signal auf dem Wellenleiter 1 erzeugt somit im Bereich des Ankoppelbereichs 24 ein entsprechendes Spannungssignal auf dem Mittelleiter 21. Diese Form der Ankopplung wird als induktive Ankopplung bezeichnet, da sie durch das Magnetfeld des HF-Signals auf dem Wellenleiter 1 erzeugt wird. Da die Koaxialleitung 20 bis auf den Ankoppelbereich 24 relativ weit weg vom Wellenleiter 1 angeordnet ist, ist ein entsprechend induziertes Signal in diesen Bereichen auch vernachlässigbar. Es erfolgt im wesentlichen nur eine Ankopplung im Ankoppelbereich 24.

Das so gewonnene Signal ist von seiner Phasenlage so, dass es eine Mitkopplung, das heißt eine Verstärkung der Hochfrequenzsignale, die auf dem Wellenleiter 1 anliegen, bewirkt. Es werden dabei insbesondere die Hochfrequenzsignale verstärkt, die die größten Signalamplituden auf dem Wellenleiter 1 bewirken, das heißt die Hochfrequenzsignale die frequenzmäßig optimal an die Lastverhältnisse des Wellenleiters 1 angepasst sind. Dies wird dadurch bewirkt, dass das im Ankoppelbereich 24 induzierte Signal über den Mittelleiter 21 an das Gate 6 des Transistors 2 geführt wird. Durch ein Steuersignal am Signalanschluss 16 wird die Spannung am Gate 6 des Feldeffekttransistors 2 so weit angehoben, dass ein gewisser Stromfluss von Drain 4 zu Source 5 ermöglicht wird. Durch die Mitkopplung wird dann frequenzabhängig am Gate 6 eine zusätzliche Steuerspannung am Gate 6 zur Verfügung gestellt, die ein weiteres Aufsteuern des Transistors 2 bewirkt. Das zusätzliche, mitgekoppelte Signal ist dabei frequenzabhängig und bewirkt, dass der Feldeffekttransistor 2 mit der Frequenz angesteuert wird, die optimal an die Lastverhältnisse des Wellenleiters 1 angepasst ist. Die in der Figur 2 gezeigte Form der induktiven Mitkopplung ist besonders einfach, wenn der Wellenleiter als Streifenwellenleiter ausgebildet ist.

In der Figur 3 wird ein weiteres Ausführungsbeispiel der erfindungsgemäßen Mitkopplung gezeigt. Mit den Bezugszeichen 1, 2, 3, 4, 5, 6 und 11 werden wieder die gleichen Gegenstände wie in der Figur 1 bezeichnet, die auch dieselben Funktionen wahrnehmen wie in der Figur 1 beschrieben. Der Wellenleiter 1 ist hier jedoch als Koaxialwellenleiter 30 mit einem Innenleiter 31 und einer Abschirmung 32 ausgebildet. Die Abschirmung 32 ist an dem Ende, welches dem Drainanschluss 4 benachbart ist, mit einem Masseanschluss 33 verbunden. Die Mitkopplung wird hier durch einen Leiter 40 bewirkt. Der Leiter 40 ist am einen Ende mit dem Gateanschluss 6 und am anderen Ende mit dem Masseanschluss 33 verbunden. Ausgehend von dem Masseanschluss 33 erstreckt sich der Leiter 40 in einem Ankoppelbereich 41 parallel zum Innenleiter 31. Weiterhin ist der Ankoppelbereich 41 innerhalb der Abschirmung 32 des Koaxialleiters 30 angeordnet. Der Ankoppelbereich 41 des Leiters 40 erstreckt sich ausgehend von dem Drainanschluss 4 des Koaxialleiters 30 parallel zum Innenleiter 31 ein Stück weit in Richtung auf die Zündstrecke 3 hin und verlässt dann durch die Öffnung 42 die Abschirmung 32 den Innenraum des Koaxialleiters 30 und wird auf das Gate 6 zurückgeführt.

Durch die Parallelanordnung eines Stücks des Leiters 40 im Ankoppelbereich 41 parallel zum Innenleiter 31 wird eine sogenannte kapazitive und induktive Mitkopplung bewirkt. Dies bedeutet, dass das Spannungssignal auf dem Leiter 40 durch das magnetische Feld des Innenleiters 31 und auch durch die dort auftretenden, elektrischen Spannungen bewirkt wird.

Der Vorteil der rein induktiven Mitkopplung besteht in einem einfachen Aufbau und darin, dass kein verfälschender kapazitiver Anteil besteht. Die gemischte induktive und kapazitive Mitkopplung ist von der Laufrichtung der Energie abhängig und stellt eine Richtkopplung dar.

Die Funktion der Mitkopplung nach Figur 3 entspricht wieder der Funktion wie sie bereits zur Figur 2 beschrieben wurde. Durch ein am Signalanschluss 16 angelegtes Signal, wird der Feldeffekttransistor 2 in einen Zustand gebracht, in dem er einen gewissen Stromfluss zwischen Drain 4 und Source zulässt. Im Ankoppelbereich 41 des Leiters 40 wird ein Mitkoppelsignal erzeugt, welches am Gate 6 eine zusätzliche Spannung zur Verfügung stellt. Dieses Mitkoppelsignal ist dann besonders stark, wenn es die Frequenz des HF-Signals aufweist, welche optimal an die Lastverhältnisse des Koaxialleiters 30 angepasst ist und bewirkt so eine Ansteuerung mit dieser Frequenz des Feldeffekttransistors 2. Es wird so bewirkt, dass der Feldeffekttransistor 2 immer mit der Frequenz angesteuert wird, die in der Zündstrecke 3 eine maximale Spannung erzeugt. Dies funktioniert vor allen Dingen auch dann, wenn sich durch das Zünden eines Zündfunkens in der Zündstrecke 3 der Abschlusswiderstand und somit auch der Wellenwiderstand des Wellenleiters 1, der hier als Koaxialleiter 30 ausgestaltet ist, ändert.

## Patentansprüche

1. Hochfrequenzzündung für eine Brennkraftmaschine mit einem Wellenleiter (1) und einem Hochfrequenzverstärker (2),
- wobei an einem ersten Ende des Wellenleiters (1) der Hochfrequenzverstärker (2) und an einem zweiten Ende des Wellenleiters (1) eine Zündstrecke (3) angeordnet sind,
- wobei ein Mitkoppelelement (10) vorgesehen ist, mit dem zusammen der Wellenleiter (1) und der Hochfrequenzverstärker (2) einen Hochfrequenzgenerator bildet, der mit einer Frequenz schwingt, bei der die durch die Länge und die Lastverhältnisse des Wellenleiters (1) bestimmte Dämpfung am geringsten ist,
- wobei ein von dem Hochfrequenzgenerator erzeugtes Hochfrequenzsignal zu einem Zündfunken in der Zündstrecke (3) führt.

2. Hochfrequenzzündung nach Anspruch 1, **dadurch gekennzeichnet, dass** der Hochfrequenzverstärker (2) als Transistor, insbesondere als Feldeffekttransistor, ausgebildet ist.

3. Hochfrequenzzündung nach einem der vorhergehenden Ansprüche, **dadurch gekennzeichnet, dass** das Mitkoppelelemtn (10) eine induktive Mitkopplung mit dem Wellenleiter (1) aufweist.

4. Hochfrequenzzündung nach Anspruch 3, **dadurch gekennzeichnet, dass** das Mitkoppelelement (10) als Koaxialleiter (20) ausgebildet ist, dass der Koaxialleiter (20) einen Ankoppelbereich (24) aufweist, der sich im Bereich des magnetischen Feldes des Wellenleiters (1) parallel zum Wellenleiter (1) erstreckt.

5. Hochfrequenzzündung nach Anspruch 1 oder 2, **dadurch gekennzeichnet, dass** das Mitkoppelelement als induktives und kapazitives Mitkoppelelement ausgebildet ist.

6. Hochfrequenzzündung nach Anspruch 5, **dadurch gekennzeichnet, dass** der Wellenleiter (1) als Koaxialleiter mit einem Mittelleiter (31) und einer Abschirmung (32) ausgebildet ist, und dass das Mitkoppelelement einen Ankoppelbereich (41) aufweist, wobei der Ankoppelbereich (41) als Leiter ausgebildet ist, der sich parallel zum Mittelleiter (31) innerhalb der Abschirmung (32) erstreckt.

## Claims

1. High-frequency ignition system for an internal combustion engine, having a waveguide (1) and a high-frequency amplifier (2),
- the high-frequency amplifier (2) being arranged at a first end of the waveguide (1), and an ignition system (3) being arranged at a second end of the waveguide (1),
- a coupling element (10), together with which the waveguide (1) and the high-frequency amplifier (2) form a high-frequency generator, being provided, said high-frequency generator oscillating at a frequency at which damping determined by the length and the load conditions of the waveguide (1) is at its least,
- a high-frequency signal which is generated by the high-frequency generator bringing about an ignition system spark in the ignition system (3).

2. High-frequency ignition system according to Claim 1, **characterized in that** the high-frequency amplifier (2) is embodied as a transistor, in particular as a field-effect transistor.

3. High-frequency ignition system according to one of the preceding claims, **characterized in that** the coupling element (10) couples inductively to the waveguide (1).

4. High-frequency ignition system according to Claim 3, **characterized in that** the coupling element (10) is embodied as a coaxial conductor (20), **in that** the coaxial conductor (20) has a coupling region (24) which extends parallel to the waveguide (1), in the region of the magnetic field of the waveguide (1).

5. High-frequency ignition system according to Claim 1 or 2, **characterized in that** the coupling element is embodied as an inductive and capacitive coupling element.

6. High-frequency ignition system according to Claim 5, **characterized in that** the waveguide (1) is embodied as a coaxial conductor with a central conductor (31) and a screen (32), and **in that** the coupling element has a coupling region (41), the coupling region (41) being embodied as a conductor which extends parallel to the central conductor (31), inside the screen (32).

## Revendications

1. Allumage haute fréquence pour un moteur à combustion interne, comprenant un guide d'ondes (1) et un amplificateur haute fréquence (2), dans lequel l'amplificateur haute fréquence (2) est sur une première extrémité du guide d'ondes (1) et un chemin d'allumage (3) est à la deuxième extrémité du guide d'ondes (1),
- un élément d'accouplement (10) est prévu, avec lequel le guide d'ondes (1) et l'amplificateur haute fréquence (2) forment un générateur haute fréquence qui oscille à une fréquence à laquelle l'amortissement déterminé par la longueur et les rapports de charge du guide d'ondes (1) est le plus faible, et
- un signal haute fréquence du générateur haute fréquence conduit à une étincelle d'allumage dans le chemin d'allumage.

2. Allumage haute fréquence selon la revendication 1,
**caractérisé en ce que**
l'amplificateur haute fréquence (2) est un transistor, en particulier un transistor à effet de champ.

3. Allumage haute fréquence selon l'une quelconque des revendications précédentes,
**caractérisé en ce que**
l'élément d'accouplement (10) présente un accouplement inductif avec le guide d'ondes (1).

4. Allumage haute fréquence selon la revendication 3,
**caractérisé en ce que**
l'élément d'accouplement (10) est un conducteur coaxial (20), le conducteur coaxial (20) présentant une zone d'accouplement (24) qui s'étend dans la zone du champ magnétique du guide d'ondes (1) parallèlement au guide d'ondes (1).

5. Allumage haute fréquence selon la revendication 1 ou 2,
**caractérisé en ce que**
l'élément d'accouplement est on élément d'accouplement inductif et capacitif.

6. Allumage haute fréquence selon la revendication 5,
**caractérisé en ce que**
le guide d'ondes (1) est un de conducteur coaxial avec un conducteur central (31) et un blindage (32), et l'élément d'accouplement présente une zone d'accouplement (41) en forme d'un conducteur parallèle au conducteur central (31) à l'intérieur du blindage (32).
